# EUROPÄISCHE PATENTSCHRIFT

(11) **EP 2 570 289 B1**
(45) Veröffentlichungstag und Bekanntmachung des Hinweises auf die Patenterteilung: **15.08.2018**
(21) Anmeldenummer: 12156318.3
(22) Anmeldetag: 21.02.2012
(51) Int. Cl.: B60L 3/00, G01R 27/02, G01R 31/02

(54) **Einrichtung zur Erfassung des Isolationswiderstandes eines Hochvoltbatteriesystems**
Device for determining the insulation resistance of a high-voltage battery system
Dispositif de détection de la résistance de l'isolement d'un système de batterie haute tension

(30) Priorität: 16.09.2011 US 201161535611 P
(43) Veröffentlichungstag der Anmeldung: 20.03.2013
(73) Patentinhaber: Samsung SDI Co., Ltd., Yongin-si, Gyeonggi-do (KR)
(72) Erfinder: Hausberger, Ingo, 8020 Graz (AT); Kober, Andreas, 8311 Markt Hartmannsdorf (AT); Lettner, Markus, 8521 Wettmannstätten (AT); Mandic, Renato, 8010 Graz (AT)
(74) Vertreter: Gulde & Partner

(56) Entgegenhaltungen:
- EP-A1- 1 289 094
- EP-A1- 1 598 929
- EP-A1- 1 857 825
- JP-A- 2003 169 401
- JP-A- 2003 324 801
- JP-A- 2009 268 214
- US-A1- 2007 285 057

## Beschreibung

Die Erfindung betrifft eine Einrichtung zur Erfassung des Isolationswiderstandes eines Hochvoltbatteriesystems der Art von Anspruch 1 .

Die Hochvoltsysteme von elektrisch unterstützten oder vollelektrisch angetriebenen Fahrzeugen müssen hinsichtlich Ihres Isolationsniveaus überwacht werden. Die Spannungen auf der Batterieseite haben ein Niveau von bis zu mehreren 100 Volt - HV-Bereich (Hochvoltbereich). Die Batterien sind Im HV-Bereich über HV-Schütze mit einer Hochvoltkomponente in Form einer Stromverteilung gekoppelt. Die Stromverteilung beaufschlagt bspw. die Umrichter für die Antriebsmaschinen im Antriebs- bzw. Generatormodus. Die entsprechenden Maschinen werden von den Umrichtern wiederum Im Hochspannungsbereich mit Wechselstrom beaufschlagt (drei Phasen). Über einen DC/DC-Wandler wird ferner auch das Im Niedervoltbereich ausgelegte Bordnetz (12V, 24V) versorgt. Die Hochvoltelektrik und die Niedervoltelektrik sind hierbei galvanisch voneinander getrennt. Sämtliche Leitungen des HV-Bereichs (also sowohl die Plus- als auch die Minusleitung auf der DC-Seite) sind gegenüber der Fahrzeugmasse, der Karosserie Isoliert.

Die Isolation und Leitungsgestaltung ist dabei dergestalt, dass ein Isolationsfehler einer Leitung, eines Poles nicht direkt zu einer Gefährdung, also zu einer gefährlichen Berührspannung zwischen Gehäuse und Erde führt. Auch bewirkt ein derartiger erster Isolationsfehler keinen Kurzschluss der Batteriepole. Dies ist erst dann der Fall, wenn auch die zweite Leitung einen Isolationsfehler aufweist. Um derartige Isolationsfehler möglich früh festzustellen, sind Isolationserfassungssysteme vorgesehen, weiche als On-Bord Einrichtung ständig den Isolationszustand prüfen und dem Fahrer anzeigen bzw. Schutzmaßnahmen einleiten.

Die DD 279 958 A1 beschreibt bei einem elektrisch angetriebenen Fahrzeug eine Schaltungsanordnung zur Überwachung des Isolationszustandes eines Fahrstromkrelses gegenüber anderen Fahrzeugteilen. Vorgesehen Ist ein einseitig an der Fahrzeugmasse anliegender Wechselspannungsgenerator, der einen dem minimal zulässigen Isolationswiderstand angepassten Innenwiderstand aufweist.

Der Wechselspannungsgenerator ist über Kondensatorschaltungen an den zu überwachenden Fahrstromkrels geführt. Der Ausgang ist mit einem Schwellwertschalter verbunden. Der Schwellwertschalter reagiert auf Unterschreitung der Wechselspannung.

Die DE 43 39 946 A1 beschreibt ein Verfahren zur Isolationsüberwachung von ungeerdeten Gleichstromnetzen. Über eine ohmsche Netzankopplung werden abwechselnd verschiedene Impulsspannungswerte als Messspannung angelegt. Der sich im eingeschwungenen Zustand ergebene Messstrom wird erfasst. Zur Bestimmung des ohmschen Isolationswiderstandes werden Differenzen aufeinanderfolgender Messstromwerte herangezogen.

Eine Schaltungsanordnung zur Bestimmung des Isolationswiderstandes einer Akkumulatorenbatterie beschreibt die DE 196 18 897 B4. Gemessen wird die Leerlaufspannung und die Belastungsspannung, wozu zwischen den Batterleklemmen zwei Kondensatoren in Reihe geschaltet sind. Der gemeinsame Punkt der Kondensatoren ist über einen Ableitwiderstand gegen Masse geschaltet. Durch Schaltmittel werden Messverstärker für vorbestimmte Zelten zur Messung der sich an den Kondensatoren einstellenden Teilspannungen geschaltet.

Eine Schaltungsanordnung zur Isolations- und Schützüberwachung der Stromversorgung eines Elektroantriebes zeigt die DE 10 2006 050 529 A1. Hochvoltbatterie und Leistungselektronik sind über Schütze miteinander geschaltet. Eine mit der Fahrzeugmasse verbundene Spannungsquelle erzeugt eine Messspannung. Zwel Spannungsmesseinrichtungen messen die durch die Messspannung erzeugten Spannungshübe gegenüber der Fahrzeugmasse. Die Spannungsquelle koppelt über Messwiderstände die Messspannung auf die Leitung, derart, dass zwischen Einspeisepunkt und Messpunkt mindestens ein Schütz geschaltet ist.

Zur Überprüfung der Kontaktierung einer Hochvoltbatterie mit den Leitungen eines Hochvoltsystems schlägt die DE 10 2008 012 418 A1 einen parallel zu Last angeordneten Kondensator vor, der über einen Vorladewiderstand geladen und Im von der Batterie abgeschalteten Zustand auf einen vorgesehenen niedrigeren Spannungswert entladen wird. Als Kondensator kann der des Zwischenkreises eines Wechselrichters genutzt werden. Das Ausbleiben eines Ladestromes über den Ladewiderstand wird als nicht ordnungsgemäße Verbindung der Batterie mit dem Hochvoltsystem gewertet.

Die EP 1 857 825 A1 beschreibt eine Messanordnung zur Ermittlung des Isolationswldorstandes einer unter Spannung stehenden elektrischen Vorrichtung. Vorgesehen sind zwei Schalter, mittels denen in zwei aufeinanderfolgenden Messungen und wechselweise geöffneten Schaltern ein jeweils ein Strompfad zwischen einem der Pole und einem Erdungspunkt herstellbar ist.

Die EP 1 289 094 A1 beschreibt eine Schaltung zur Feststellung eines Kurzschlusses. Die Schaltung umfasst Messwiderstände und Schalter sowie eine Spannungsmessung.

Die US 2007/285057 A1 und die JP 2003 169 401 A betreffen eine Vorrichtung zu Feststellung eines Fehlerstromes in einem Elektrofahrzeug. Die Vorrichtung umfassen Schalter, Messwiderstände und eine Spannungsmessvorrichtung.

Aufgabe der vorliegenden Erfindung Ist es daher, eine Einrichtung zur Erfassung des Isolationswiderstandes eines Hochvoltbatteriesystems der beschriebenen Art In verbesserter Ausführung vorzuschlagen, Insbesondere mit dem Ziel eines reduzierten Bauteilaufwandes.

Diese Aufgabe wird gelöst durch die Merkmale von Anspruch 1.

Zur Bestimmung des Isolationswiderstandes wird der Referenzwiderstand abwechselnd parallel zu den Isolationswiderständen geschaltet. Es werden die Spannungen zwischen den Polen und dem Bezugspotential gemessen, nachdem die parasitären Kapazitäten umgeladen wurden. Nachdem der Referenzwiderstand einmal auf beide Pole der Hochvoltbatterie geschaltet, kann der Isolationswiderstand berechnet werden. Dieser entspricht dann - abhängig von den Schaltzuständen der Schalter, Schütze - einem Widerstandswert einer Parallelschaltung der Isolationswiderstände nur des Batteriesystems bzw. einem Widerstandswert einer Parallelschaltung der Isolationswiderstände der Batterie sowie der der Hochvoltkomponente.

Die erfindungsgemäße Einrichtung zur Erfassung des Isolationswiderstandes kommt ohne zusätzliche Prüfquelle aus. Der Energiespeicher, die Hochvoltbatterie wird als Prüfquelle benutzt.

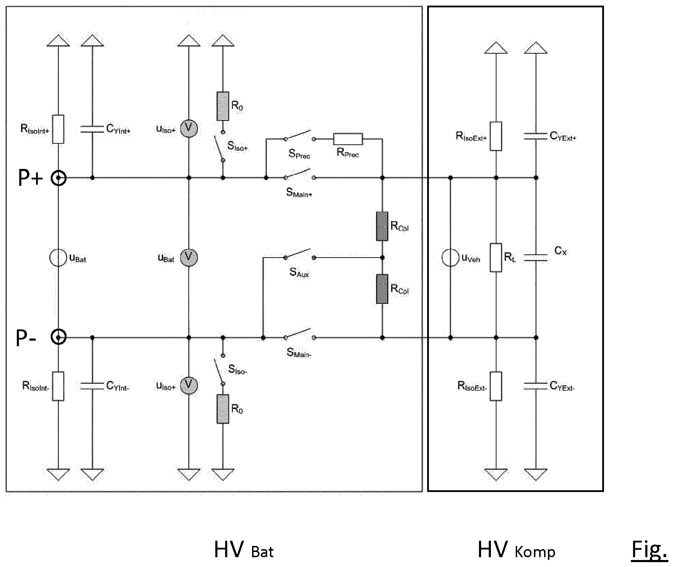

Des Weiteren erfolgt die Erläuterung von Ausführungsbeispielen der Erfindung an Hand der Zeichnung. Diese zeigt als Prinzipschaltbild eine Hochvoltbatterie, welche mit ihren Polen über Schütze an eine Hochvoltkomponente geschaltet ist.

Die beiden Pole P+, P- einer Hochvoltbatterie HV_{Bat} eines nicht dargestellten Kraftfahrzeuges sind über schaltbare Schütze S_{Main+}, S_{Main-} mit einer Hochvoltkomponente HV_{Komp} verbunden. Jeder Batteriepol P+, P- weist gegenüber dem Bezugspotential, der Fahrzeugkarosserie, einen Isolationswiderstand R_{IsoInt+}, R _{IsoInt-} auf. Ebenfalls besitzt jeder der Pole eine parasitäre Kapzität C_{Yint+}, C_{Yint-}. Ein Referenzwiderstand R₀ ist über steuerbare Schalter S_{Iso+}, S_{Iso-} wahlweise an den Plus- bzw. den Minuspol P+, P- der Hochvoltbatterie schaltbar. Die Schalter S_{Iso+}, S_{Iso-} sind als Transistoren (MOSFET) ausgeführt und so von einer Steuerung her schaltbar. Über eine Spannungsmessvorrichtung zwischen dem jeweiligen Pol P+, P- und dem Bezugspotential des Fahrzeuges wird die jeweils anliegende Spannung U_{Iso+}, U_{Iso-} gemessen. Mit einer weiteren Spannungsmessvorrichtung wird direkt die an den Batteriepolen P+, P- liegende Spannung U_{Bat} gemessen.

Über einen als Relais ausgeführten Schalter S_{Aux} kann der Mittelpunkt einer aus zwei Widerständen R_{Cpl} gebildeten Koppelschaltung direkt mit einem der Batteriepole - im gezeigten Fall der Minuspol P- - verbunden werden. Parallel zu dem den Pluspol P+ mit der Hochvoltkomponente HV_{Komp} verbindenden Schütz S_{Main+} ist ein über einen Schalter S_{Prec} ein Ladewiderstand R_{Prec} zum Laden der Hochvoltbatterie HV_{Bat} vorschaltbar.

Analog der Situation der Hochvoltbatterie HV_{Bat} besitzt die Hochvoltkomponente HV_{Komp} einen Isolationswiderstand R_{Isoext+}, R_{Isoext-}. Ebenfalls besitzt jeder der Pole der Hochvoltkomponente HV_{Komp} eine parasitäre Kapzität C_{YExt+}, C_{YExt-}. Die an dem Eingang der Hochvoltkomponente HV_{Komp} anliegende Spannung ist mit U_{Veh} angegeben. Die ohmsche Last der Hochvoltkomponente HV_{Komp} beträgt R_{L}, die Kapazität C_{X}.

Um den Isolationswiderstand zu bestimmen, wird der bekannte Referenzwiderstand R₀ abwechselnd parallel zum Isolationswiderstand R_{IsoInt+}, R_{IsoInt-} geschaltet. Zusätzlich werden die Spannungen zwischen den Polen P+, P- und dem Bezugspotential U_{Iso+}, U_{Iso-} gemessen, nachdem die parasitären Kapazitäten C_{Yint+}, C_{Yint-}, C_{YExt+}, C_{YExt-} umgeladen wurden. Nachdem der Referenzwiderstand R₀ einmal auf beide Pole P+, P- geschaltet wurde, kann der Isolationswiderstand berechnet werden.

Abhängig von den Schaltzuständen der Schalter, Schütze S_{Main+}, S_{Main-}, S_{Prec} und S_{Aux} ergibt sich für den Widerstand R_{Iso}:
- S_{Main+}, S_{Main-}, S_{Aux} oder S _{Prec} geschlossen:
   -> R_{Iso} entspricht der Parallelschaltung von R_{IntIso+}, R_{IntIso-}, R_{ExtIso+} und R_{ExtIso-}
- S_{Main+}, S_{Main-}, S_{Prec} und S_{Aux} offen:
   -> R_{Iso} entspricht der Parallelschaltung von R_{IntIso+}, R_{IntIso-}

### Bezugszeichen

- R _{IsoInt+}: Isolationswiderstand Intern (Hochvoltbatterie) Pluspol
- R _{IsoInt-}: Isolationswiderstand Intern (Hochvoltbatterie) Minuspol
- R _{IsoExt+}: Isolationswiderstand Extern (Hochvoltkomponente) Pluspol
- R _{IsoExt-}: Isolationswiderstand Extern (Hochvoltkomponente) Minuspol
- R _{L}: Widerstand Last (Hochvoltkomponente)
- R _{Prec}: Ladewiderstand
- R₀: Referenzwiderstand
- R _{Cpl}: Koppelschaltung, Koppelwiderstand
- C _{YInt+}: Kapazität Intern (Hochvoltbatterie) Pluspol
- C _{YInt-}: Kapazität Intern (Hochvoltbatterie) Minuspol
- C _{YExt+}: Kapazität Extern (Hochvoltkomponente) Pluspol
- C _{YExt-}: Kapazität Extern (Hochvoltkomponente) Minuspol
- C _{X}: Kapazität Hochvoltkomponente
- U _{Iso+}: Messspannung Pluspol (Batterie) - Bezugspotential
- U _{Iso-}: Messspannung Minuspol (Batterie) - Bezugspotential
- U _{Bat}: Batteriespannung
- S _{Iso+}: Schalter - Referenzwiderstand R₀ gegenüber Pluspol P+
- S _{Iso-}: Schalter - Referenzwiderstand R₀ gegenüber Minuspol P-
- S _{Aux}: Schalter, Relais - Beaufschlagung der Koppelschaltung
- S _{Main+}: Schütz Pluspol Batterie
- S _{Main-}: Schütz Minuspol Batterie
- S _{Prec}: Schalter Laden Batterie - Vorwiederstand R_{Prec}
- HV _{Bat}: Batterie - Hochvoltbatterie
- HV _{Komp}: Hochvoltkomponente - z.B. Umrichter

## Patentansprüche

1. Einrichtung zur Erfassung des Isolationswiderstandes eines Hochvoltbatteriesystems, vorzugsweise eines Kraftfahrzeuges, mit
- einer Hochvoltbatterie (HV_{Bat}), welche gleichzeitig die Prüfquelle ist,
- einer über schaltbare Schütze (S_{Main+}, S_{Main-}) mit den Batteriepolen (P+, P-) verbundenen Hochvoltkomponente (HV_{Komp}),
- einer Steuerung,
wobei zur Erfassung des Isolationswiderstandes folgendes vorgesehen ist:
- ein Referenzwiderstand (R₀),
- über die Steuerung betätigbare Schalter (S_{Iso+}, S_{Iso-}), um den Referenzwiderstand (R₀) wahlweise an die Pole der Hochvoltbatterie (HV_{Bat}) zu schalten,
- eine Spannungsmessvorrichtung zur Erfassung der zwischen dem jeweiligen Pol und dem Bezugspotential des Fahrzeuges (Karosserie) anliegenden Spannung in Abhängigkeit der Schalterzustände,
- einer Spannungsmessvorrichtung zur Messung der Hochspannung zwischen den Polen (U_{Bat}) der Hochvoltbatterie (HV_{Bat}),
- einer Koppelschaltung zur Überwachung der externen Hochvoltkompo-nente (HV _{Komp}) bei geöffneten Schützen (S_{Main+}, S_{Main-}), wobei der Mittelpunkt der aus zwei Widerständen (R_{Cpl}) gebildeten Koppelschaltung direkt mit einem der Batteriepole (P+) oder (P-) über einen weiteren, über die Steuerung betätigbaren Schalter (S_{Aux}) verbindbar ist.

2. Einrichtung nach Anspruch 1, **dadurch gekennzeichnet, dass** die Hochvoltkomponente (HV_{Komp}) ein Umrichter ist.

## Claims

1. Device for detecting the insulation resistance of a high-voltage battery system, preferably of a motor vehicle, comprising:
- a high-voltage battery (HV_{Bat}), which at the same time is the check source,
- a high-voltage component (HV_{Komp}), which is connected to the battery terminals (P+, P-) via switchable contactors (S_{Main+}, S_{Main-}),
- a controller,
wherein the following is provided in order to detect the insulation resistance:
- a reference resistor (R₀),
- switches (S_{Iso+}, S_{Iso-}) which can be operated via the controller in order to switch the reference resistor (R₀) selectively onto the terminals of the high-voltage battery (HV_{Bat}),
- a voltage measuring device for detecting the voltage present between the respective terminal and the reference potential of the vehicle (vehicle body) depending on the switch states,
- a voltage measuring device for measuring the high voltage between the terminals (U_{Bat}) of the high-voltage battery (HV_{Bat}),
- a coupling circuit for monitoring the external high-voltage component (HV_{Komp}) when the contactors (S_{Main+}, S_{Main-}) are open, wherein the mid-point of the coupling circuit formed of two resistors (R_{Cpl}) can be connected directly to one of the battery terminals (P+) or (P-) via a further switch (S_{Aux}) which can be operated via the controller.

2. Device according to claim 1, **characterized in that** the high-voltage component (HV_{Komp}) is a converter.

## Revendications

1. Dispositif de détection de la résistance d'isolement d'un système de batterie haute tension, de préférence d'un véhicule automobile, comprenant :
- une batterie haute tension (HV_{Bat}), laquelle est simultanément la source de contrôle,
- un composant haute tension (HV_{Komp}) relié aux pôles de batterie (P+, P-) par des contacteurs (S_{Main+}, S_{Main-}) commutables,
- une commande,
dans lequel les éléments suivants sont prévus pour détecter la résistance d'isolement :
- une résistance de référence (R₀),
- des commutateurs (S_{Iso+}, S_{Iso-}) pouvant être actionnés par la commande, afin de commuter la résistance de référence (R₀) sélectivement sur les pôles de la batterie haute tension (HV_{Bat}),
- un dispositif de mesure de tension destiné à détecter la tension appliquée entre le pôle respectif et le potentiel de référence du véhicule (carrosserie) en fonction des états des commutateurs,
- un dispositif de mesure de tension destiné à mesurer la haute tension entre les pôles (U_{Bat}) de la batterie haute tension (HV_{Bat}),
- un circuit de couplage destiné à surveiller le composant haute tension (HV_{Komp}) externe lorsque les contacteurs (S _{Main+}, S_{Main-}) sont ouverts, dans lequel le centre du circuit de couplage formé de deux résistances (R_{Cpl}) peut être relié directement à l'un des pôles de batterie (P+) ou (P-) par un autre commutateur (S_{Aux}) pouvant être actionné par la commande.

2. Dispositif selon la revendication 1, **caractérisé en ce que** le composant haute tension (HV_{Komp}) est un convertisseur.
